# EUROPEAN PATENT SPECIFICATION

(11) **EP 0 241 835 B1**
(45) Date of publication and mention of the grant of the patent: **10.03.1993**
(21) Application number: 87105062.1
(22) Date of filing: 06.04.1987
(51) Int. Cl.: G01R 13/40, H03M 1/58

(54) **Circuit for driving a multiple-element display**
Treiberschaltung für eine Anzeige bestehend aus einer Vielzahl von Einzelelementen
Circuit de commande pour un affichage composé d'éléments multiples

(30) Priority: 10.04.1986 US 850198
(43) Date of publication of application: 21.10.1987
(73) Proprietor: TEKTRONIX, INC., Beaverton Oregon 97077 (US)
(72) Inventor: Cleary, Edward J., Beaverton Oregon 97005 (US); Coleman, Mike R., Beaverton Oregon 97005 (US); Jones, Michael R., Anaheim California 92806 (US)
(74) Representative: Baillie, Iain Cameron

(56) References cited:
- DE-A- 1 623 872
- DE-A- 2 851 437
- GB-A- 1 334 846
- GB-A- 1 524 802

## Description

This invention relates to a circuit for driving a multiple-element display.

### Background of the Invention

It is conventional to use a meter having a deflectable needle to indicate audio signal amplitude. In such a meter, the needle deflection is normally directly proportional to signal amplitude, but the meter scale is usually calibrated in decibels because the perception of loudness is a logarithmic function of signal amplitude. An analog audio meter of this type suffers from the problem that its useful dynamic range is very small compared to the dynamic range of audio signals. The amplitude of a signal that is 20 dB below full scale is one-tenth of full scale amplitude, but audio program material typically has a dynamic range exceeding 60 dB. Consequently, most of that range will barely deflect a linear meter.

Many methods are used to make the indication given by a conventional analog meter more logarithmic, or dB-linear, in order to increase the dynamic range over which the needle is deflected to a readily-perceptible degree, including use of non-linear meter movements and log-shaping networks.

Electronic bar graph meters employ multiple light-emitting diodes (LEDs). It is conventional to use such bar graph meters to indicate audio signal amplitude, and log-weighted amplitude sensing circuits are used in order to provide a dB-linear display.

DE-A-1623872 discloses a circuit for displaying a voltage value on a bar graph display converting the voltage value to a frequency and then counting the number of frequency pulses per fixed clock interval or by counting the pulses of a fixed frequency clock during a variable interval of time that is determined by the voltage value compared to a ramp signal generated from the fixed frequency clock. This prior art does not provide a predetermined or selectable transfer function whereby a bar graph is able to display in other than linear voltage terms.

There is disclosed in DE-A-2851437 a circuit for driving a bar graph display tube, having a clock connected to a period counter for providing a period output on a number of outputs. These outputs are connected to a encoder whose first output converted by a digital-to-analog converter, is a reference signal varying non-linearly with time.

A comparator compares an input to this non-linear reference, and its output controls the anode of the display tube. This prior art does not have a display in which a distinct one of the elements is activated for each value output by the counter, and is not suitable for use with an electronic bar graph meter.

### Summary of the Invention

According to this invention there is provided a circuit for driving a display device having n display elements, where n is a positive integer greater than one, having a periodic counter that provides a repetitive digital signal with a predetermined sequence of n digital values, and having a comparator for comparing an analog signal derived via a digital-to-analog converter from the repetitive digital signal with an input signal to generate a display enable signal, the circuit being characterised by:
a read-only memory correction table having a plurality of separately selectable look-up tables, each look-up table having a unique transfer function, the correction table being responsive to the repetitive digital signal for providing a second repetitive digital signal having a second predetermined sequence of n digital values from which the analog signal is derived, and the correction table having a scale select input for receiving a signal operative to select one of the separately selectable look-up tables; and
decoder means, having the n digital values as inputs and a plurality of output terminals coupled to the n display elements so that for each of the n digital values only a distinct one of the display elements is activated, for providing in response to the display enable signal a visual indication of the value of the input signal.

### Brief Description of the Drawings

For a better understanding of the invention, and to show how the same may be carried into effect, reference will now be made, by way of example, to the accompanying drawings in which:
Figure 1 is a block diagram of an audio level meter embodying the present invention, and
Figure 2 shows graphs illustrating operation of the Figure 1 audio level meter.

### Detailed Description

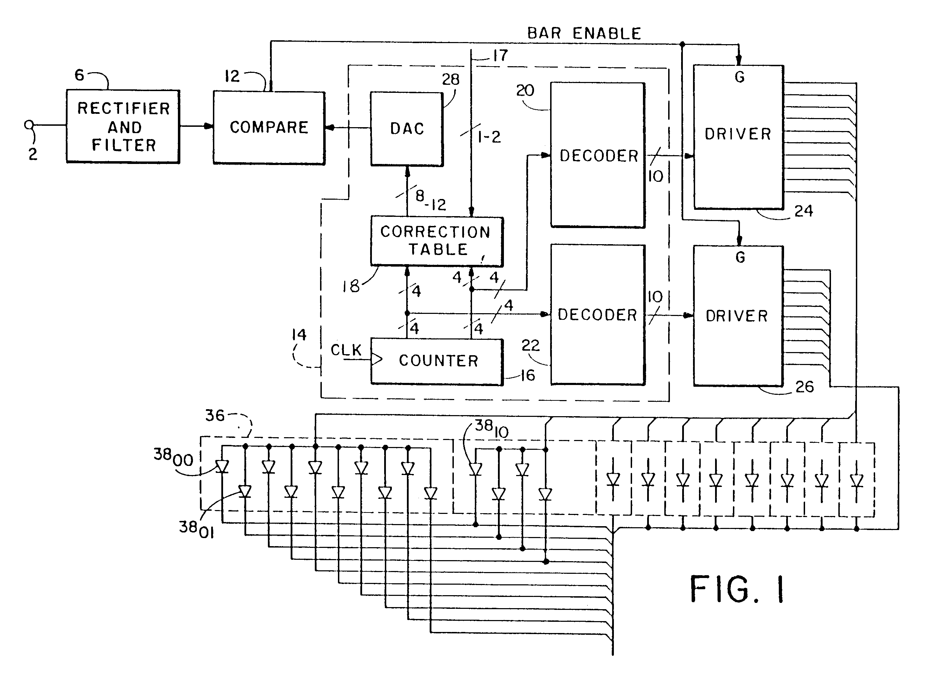

The audio level meter shown in Figure 1 has an input terminal 2 that receives an audio input signal and is connected to a rectifier and filter 6. The nature of the filter determines the characteristic of the audio input signal that is measured by means of the audio level meter. The output signal of the rectifier and filter 6 is applied to a comparator 12, which receives a reference signal from a reference signal generator 14.

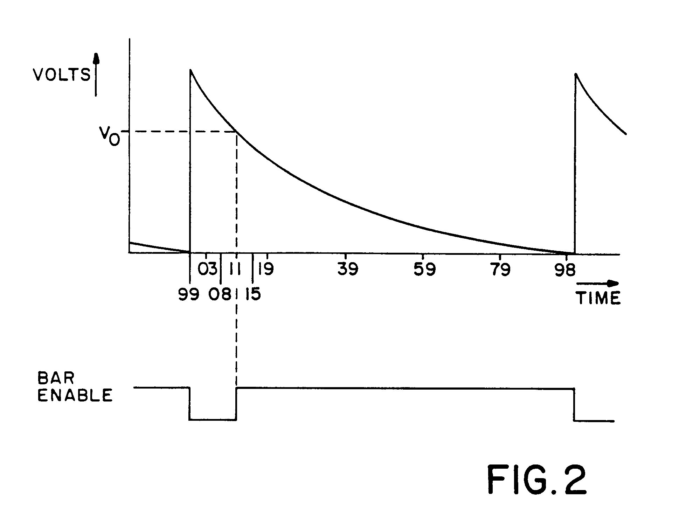

The reference signal generator 14 comprises a counter 16 which receives a clock signal at its clock input and has two groups of four signal output lines on which it provides a two digit binary coded decimal signal. The BCD signal provided by the counter 16 steps down consecutively through the series of digits representing the decimal numbers 00 through 99. The output lines from the counter 16 are applied to a correction table 18. Also, the higher and lower order groups of lines are applied to respective BCD-to-decimal decoders 20 and 22. The two decoders 20 and 22 each have ten output lines connected to LED drivers 24 and 26. The correction table 18 is a read-only memory (ROM) that contains up to four look-up tables that are separately selectable under control of a signal applied to scale select lines 17 of the ROM. The selected look-up table transforms each of the 100 possible digital input values into a digital word that is applied to a digital-to-analog converter (DAC) 28. The DAC 28 converts the digital output signal provided by the correction table 18 into an analog signal that is applied to the reference terminal of the comparator 12. Therefore, as the clock pulses are received by the counter 16, and the counter steps through its 100 possible states, the analog output signal of the DAC 28 provides a repetitive output signal that depends upon the selected look-up table and the transfer function of the DAC 28. The frequency of the clock signal is about 30 kHz, and therefore the frequency of the analog output signal of the DAC 28 is about 300 Hz. Preferably, the amplitude of the analog output signal decreases as the count decreases from 99 to 00 and increases from its minimum value to its maximum value when the counter resets from the end of its counting sequence (00) to the beginning of the next counting sequence (99), as shown in the top waveform of FIG. 2. The dynamic range of the reference signal voltage corresponds substantially to the dynamic range of the signal voltage applied to the comparator 12 by the rectifier and filter 6. Preferably, the correction table has 12 output lines in order to enable the output signal of the DAC to conform to a desired waveform with a high degree of accuracy.

If the amplitude of the output signal of the DAC 28 is equal to or less than the amplitude of the output signal provided by the rectifier and filter 6, the comparator 12 provides an output signal that is a logical 1. Otherwise, the output signal of the comparator is a logical 0. The output signal of the comparator 12 is applied to the bar enable terminals of the driver circuits 24 and 26.

Each of the drivers 24 and 26 defines ten amplification channels extending between input terminals of the driver and respective output terminals thereof. Each driver is enabled, and thus is able to conduct current between an input terminal and the associated output terminal, if the driver receives a logical 1 at its bar enable terminal G.

The output terminals of the drivers 24 and 26 are connected to a bar graph display 36 comprising a linear array of one hundred LEDs 38₀₀ to 38₉₉. The anodes of the diodes 38ₚ₀ to 38ₚ₉ (where p is an integer from 0 to 9) are all connected together and are connected to the pth output terminal of the driver 24. The cathodes of the LEDs 38_{0q} to 38_{9q} (where q is an integer from 0 to 9) are connected together and are connected to the qth output terminal of the driver 26. The drivers 24 and 26 are enabled only when they receive a logical 1 at their bar enable terminals G. Therefore, the diode 38_{pq} receives energizing current only when the state of the counter 16 represents the decimal number pq and the comparator 12 provides a logical 1 at its output terminal. If, for example, the combined transfer function of the correction table 18 and the DAC 28 is such that the output voltage of the DAC 28 follows the upper waveform shown in FIG. 2, and the amplitude of the output signal of the rectifier and filter 6 is Vₒ, as the amplitude of the output signal provided by the DAC 28 falls and becomes equal to Vₒ, the comparator 12 provides a logical 1 at its output terminal and continues to provide a logical 1 until the start of the next repetition of the output signal of the DAC 28, as indicated by the lower waveform in FIG. 2. Consequently, the LED associated with the state of the counter at which the output transition of the comparator 12 occurred, and the LEDs associated with the succeeding states of the counter, are successively energized.

The reference signal generator 14 can be used to control several different audio signal channels, such as left and right signal channels in the case of a stereophonic system, and the transfer function relating detected signal amplitude to the number of energized LEDs is identical for each channel. The transfer function can be readily changed by selecting a different look-up table in the correction table 18 using the scale select lines 17.

It will be appreciated that the present invention is not restricted to the particular circuit that has been described and illustrated, and that variations may be made therein without departing from the scope of the invention as defined in the appended claims.

## Claims

1. A circuit for driving a display device (36) having n display elements, where n is a positive integer greater than one, having a periodic counter (16) that provides a repetitive digital signal with a predetermined sequence of n digital values, and having a comparator (12) for comparing an analog signal derived via a digital-to-analog converter (28) from the repetitive digital signal with an input signal to generate a display enable signal, the circuit being characterised by:
a read-only memory correction table (18) having a plurality of separately selectable look-up tables, each look-up table having a unique transfer function, the correction table being responsive to the repetitive digital signal for providing a second repetitive digital signal having a second predetermined sequence of n digital values from which the analog signal is derived, and the correction table having a scale select input for receiving a signal operative to select one of the separately selectable look-up tables; and
decoder means (20-26), having the n digital values as inputs and a plurality of output terminals coupled to the n display elements so that for each of the n digital values only a distinct one of the display elements is activated, for providing in response to the display enable signal a visual indication of the value of the input signal.

2. A circuit according to claim 1, wherein the periodic counter (16) has n states and an output at which it provides a binary signal representative of its current state.

3. A circuit according to claim 1, wherein the decoder means (20-26) output terminals have n distinct, separately selectable states and the decoder means are connected to receive the repetitive digital signal and are operative to select a single state element for each of the n digital values of the repetitive digital signal.

4. A circuit according to claim 3, wherein the decoder means comprise decoders (20, 22) and amplifier means (24, 26) connected between the decoders and the display elements (38).

5. A circuit according to claim 4, wherein n is the product of m₁ and m₂, where m₁ and m₂ are positive integers, the decoders (20, 22) comprise higher and lower order decoder devices having m₁ and m₂ output terminals respectively, the amplifier means (24, 26) comprise first and second amplifiers having m₁ and m₂ amplification channels respectively, the m₁ amplification channels of the first amplifier being connected respectively to the m₁ output terminals of the higher order decoder device and the m₂ amplification channels of the second amplifier being connected respectively to the m₂ output terminals of the lower order decoder device, and wherein each display element has two terminals connected between a unique pair of terminals consisting of one output terminal of the first amplifier and one output terminal of the second amplifier.

6. A circuit according to claim 5, wherein m₁ is equal to m₂.

7. A circuit according to claim 1, wherein the comparator (12) provides a signal having a first state in the event that the amplitude of the analog signal is equal to or less than the amplitude of the second signal and otherwise provides a signal having a second value.

## Patentansprüche

1. Schaltung zum Treiben einer Anzeigevorrichtung (36) mit n Anzeigeelementen, wobei n eine positive ganze Zahl größer als Eins ist, mit einem periodischen Zähler (16), der ein periodisches Digitalsignal mit einer vorbestimmten Folge von n Digitalwerten bereitstellt, und mit einem Komparator (12) zum vergleichen eines Analogsignals, das mit einem Eingangssignal über einen Digital-Analog-Wandler (28) von dem periodischen Digitalsignal abgeleitet wird, um ein Anzeigeaktivierungssignal zu erzeugen, wobei die Schaltung gekennzeichnet ist durch:
eine Festwertspeicherkorrekturtabelle 18 mit einer Vielzahl von einzeln wählbaren Nachschlagtabellen, wobei jede Nachschlagtabelle eine eindeutige Umwandlungsfunktion hat, wobei die Korrekturtabelle anspricht auf das periodische Digitalsignal zur Bereitstellung eines zweiten periodischen Digitalsignals mit einer zweiten vorbestimmten Folge von n Digitalwerten, von denen das Analogsignal abgeleitet wird und die Korrekturtabelle einen Maßstabwahleingang zum Empfangen eines Signals hat, das eine der einzeln wählbaren Nachschlagtabellen wählt; und
Decodierereinrichtungen (20-26) mit n Digitalwerten als Eingangssignale und einer Vielzahl von Ausgängen, die an n Anzeigeelemente gekoppelt sind, so daß für jeden der n Digitalwerte nur ein deutlich unterscheidbares Element der Anzeigeelemente aktiviert wird, um, ausgelöst durch das Anzeigeaktivierungssignal, eine visuelle Anzeige des Wertes des Eingabesignals bereitzustellen.

2. Schaltung nach Anspruch 1, wobei der periodische Zähler (16) n Zustände und einen Ausgang hat, an dem er ein binäres Signal bereitstellt, das ihren aktuellen Zustand anzeigt.

3. Schaltung nach Anspruch 1, wobei die Ausgänge der Decodierereinrichtungen (20-26) n deutlich unterscheidbare, einzeln wählbare Zustände haben und die Decodiereinrichtungen verbunden sind, um das periodische Digitalsignal zu empfangen, und in Betrieb sind, um ein einzelnes Zustandselement für jeden der n Digitalwerte des periodischen Digitalsignals zu wählen.

4. Schaltung nach Anspruch 3, wobei die Decodierereinrichtungen aufweisen: Decodierer (20, 22) und Verstärkereinrichtungen (24, 26), die zwischen die Decodierer und die Anzeigeelemente (38) geschaltet sind.

5. Schaltung nach Anspruch 4, wobei n das Produkt aus m₁ und m₂ ist, wobei m₁ und m₂ positive ganze Zahlen sind, die Decodierer Decodiereinrichtungen höherer und niedrigerer Wertigkeit mit m₁ bzw. m₂ Ausgängen haben, die Verstärkereinrichtungen (24, 26) erste und zweite Verstärker mit m₁ bzw. m₂ Verstärkungskanälen aufweisen, wobei die m₁ Verstärkungskanäle des ersten Verstärkers jeweils verbunden sind mit den m₁ Ausgängen der Decodierereinrichtung höherer Wertigkeit und die m₂ Verstärkungskanäle des zweiten Verstärkers jeweils verbunden sind mit den m₂ Ausgängen der Decodierereinrichtung niedrigerer Wertigkeit und wobei jedes Anzeigeelement zwei Anschlüsse hat, die zwischen ein einmalig vorkommendes Anschlußpaar, das aus einem Ausgang des ersten Verstärkers und einem Ausgang des zweiten Verstärkers besteht, geschaltet sind.

6. Schaltung nach Anspruch 5, wobei m₁ gleich m₂ ist.

7. Schaltung nach Anspruch 1, wobei der Komparator (12) ein Signal mit einem ersten Zustand in dem Fall bereitstellt, daß die Amplitude des Analogsignals kleiner oder gleich der Amplitude des zweiten Signals ist, und anderenfalls ein Signal mit einem zweiten Wert bereitstellt.

## Revendications

1. Circuit pour commander un dispositif d'affichage (36) comportant n éléments d'affichage, où n est un entier positif supérieur à un, comportant un compteur périodique (16) qui fournit un signal numérique répétitif ayant une série prédéterminée de n valeurs numériques et comportant un comparateur (12) pour comparer un signal analogique dérivé par l'intermédiaire d'un convertisseur numérique-analogique (28) du signal numérique répétitif à un signal d'entrée pour générer un signal de validation d'affichage, le circuit étant caractérisé par:
une table de correction de mémoire morte (18) comportant une pluralité de tables de consultation pouvant être sélectionnées séparément, chaque table de consultation ayant une fonction de transfert unique, la table de correction réagissant au signal numérique répétitif pour fournir un deuxième signal numérique répétitif ayant une deuxième série prédéterminée de n valeurs numériques d'où est dérivé le signal analogique, et la table de correction comportant une entrée de sélection d'échelle pour recevoir un signal actif pour sélectionner une des tables de consultation pouvant être sélectionnées séparément; et
des moyens décodeurs (20-26), ayant les n valeurs numériques comme signaux d'entrée et une pluralité de bornes de sortie couplées aux n éléments d'affichage, de telle sorte que pour chacune des n valeurs numériques, un seul élément distinct parmi les éléments d'affichage est activé, pour fournir en réponse au signal de validation d'affichage une indication visuelle de la valeur du signal d'entrée.

2. Circuit selon la revendication 1, dans lequel le compteur périodique (16) a n états et une sortie à laquelle il fournit un signal binaire représentant son état présent.

3. Circuit selon la revendication 1, dans lequel les bornes de sortie des moyens décodeurs (20-26) ont n états distincts pouvant être sélectionnés séparément et les moyens décodeurs sont connectés pour recevoir le signal numérique répétitif et sont actifs pour sélectionner un élément d'un seul état pour chacune des n valeurs numériques du signal numérique répétitif.

4. Circuit selon la revendication 3, dans lequel les moyens décodeurs comprennent des décodeurs (20,22) et des moyens amplificateurs (24,26) connectés entre les décodeurs et les éléments d'affichage (38).

5. Circuit selon la revendication 4, dans lequel n est le produit de m₁ et m₂, où m₁ et m₂ sont des entiers positifs, les décodeurs (20,22) comprennent des dispositifs décodeurs d'ordre supérieur et d'ordre inférieur ayant respectivement m₁ et m₂ bornes de sortie, les moyens amplificateurs (24,26) comprennent des premier et second amplificateurs ayant respectivement m₁ et m₂ voies d'amplification, les m₁ voies d'amplification du premier amplificateur étant connectées respectivement aux m₁ bornes de sortie du dispositif décodeur d'ordre supérieur et les m₂ voies d'amplification du second amplificateur étant connectées respectivement aux m₂ bornes de sortie du dispositif décodeur d'ordre inférieur, et dans lequel chaque élément d'affichage comporte deux bornes connectées entre une paire unique de bornes constituée d'une borne de sortie du premier amplificateur et d'une borne de sortie du second amplificateur.

6. Circuit selon la revendication 5, dans lequel m₁ est égal à m₂.

7. Circuit selon la revendication 1, dans lequel le comparateur (12) fournit un signal ayant un premier état dans le cas où l'amplitude du signal analogique est égale ou inférieure à l'amplitude du deuxième signal et fournit autrement un signal ayant une seconde valeur.
